# EUROPÄISCHE PATENTSCHRIFT

(11) **EP 1 155 458 B1**
(45) Veröffentlichungstag und Bekanntmachung des Hinweises auf die Patenterteilung: **03.02.2010**
(21) Anmeldenummer: 98966794.4
(22) Anmeldetag: 18.12.1998
(51) Int. Cl.: H01L 29/78, H01L 29/739, H01L 29/10, H01L 21/336, H01L 21/331, H01L 29/04, H01L 29/06

(54) **FELDEFFEKT-TRANSISTORANORDNUNG MIT EINER GRABENFÖRMIGEN GATE-ELEKTRODE UND EINER ZUSÄTZLICHEN HOCHDOTIERTEN SCHICHT IM BODYGEBIET**
FIELD EFFECT TRANSISTOR ARRANGEMENT WITH A TRENCH GATE ELECTRODE AND AN ADDITIONAL HIGHLY DOPED LAYER IN THE BODY REGION
ENSEMBLE TRANSISTOR A EFFET DE CHAMP COMPORTANT UNE ELECTRODE DE GRILLE SOUS FORME DE TRANCHEE ET UNE COUCHE COMPLEMENTAIRE HAUTEMENT DOPEE DANS LA REGION DE BODY

(43) Veröffentlichungstag der Anmeldung: 21.11.2001
(73) Patentinhaber: Infineon Technologies AG, 81669 München (DE)
(72) Erfinder: PFIRSCH, Frank, D-81548 München (DE); SCHÄFFER, Carsten, A-9521 Treffen bei Villach (AT)
(74) Vertreter: Bickel, Michael
(86) Internationale Anmeldenummer: PCT/DE1998/003747
(87) Internationale Veröffentlichungsnummer: WO 2000/038244

(56) Entgegenhaltungen:
- EP-A- 0 342 952
- EP-A- 0 633 611
- WO-A-95/24055
- DE-A- 2 801 085
- DE-A- 19 629 088
- US-A- 4 969 024
- US-A- 5 468 982
- PATENT ABSTRACTS OF JAPAN vol. 006, no. 052 (E-100), 7. April 1982 (1982-04-07) & JP 56 165360 A (MATSUSHITA ELECTRONICS CORP), 18. Dezember 1981 (1981-12-18)

## Beschreibung

Die vorliegende Erfindung betrifft Feldeffekt-Transistoren mit grabenförmigen Gate-Elektroden, wobei vorgesehen sein kann, daß durch sich kreuzende Gate-Gräben eine Zellstruktur der Transistoren entsteht. Unter sich kreuzenden Gräben sind dabei Strukturen zu verstehen, bei denen sich entweder weitgehend durchgehende Gräben in einem Kreuzungspunkt überschneiden oder Gräben in einem ihrer Endpunkte unter einem bestimmten Winkel, beispielsweise unter einem rechten Winkel, miteinander verbunden sind. Die Transistoren können dabei beispielsweise als MOSFET-Transistoren wie auch als IGBT-Transistoren ausgebildet sein.

Aus dem Stand der Technik ist beispielsweise aus EP 0 847 090 oder aus GB 2 314 206 bekannt, durch sich kreuzende Gräben eine Zellstruktur von Transistoren zu bilden. Problematisch sind dabei die Bereiche in den Ecken der Zellen, in denen zwei Gräben aufeinanderstoßen. Da die dotierten Bereiche in diesen Ecken zwei Grenzflächen aufweisen, durch die Dotierstoffe ausdiffundieren können, entsteht in den Ecken der Zellen eine geringere Konzentration des Dotiermaterials als in den übrigen dotierten Bereichen der Zelle. Darüber hinaus bilden die Zellecken typischerweise Bereiche besonders hoher elektrischer Feldstärke. Die Folge ist, daß es gerade in den Zellecken zu einem unerwünscht frühen Einsetzen von Durchbruchsströmen kommt oder die Schwellspannung des Transistors in diesen Bereichen niedriger ausfällt als in den übrigen Bereichen und eventuell auch keine ausreichende Langzeitstabilität aufweist.

Es ist daher erwünscht, daß in den Ecken von Transistorzellen die Ausbildung einer Kanalregion vermieden werden kann. Aus US 5 468 982 ist hierzu eine Anordnung bekannt, bei der sich die Sourceregion nicht bis in die Ecken der Transistorzelle erstreckt. Dies kann erreicht werden, indem bei der Herstellung der Sourceregion die Zellecken maskiert werden. Nachteilig hierbei ist jedoch, daß für die Maskierung der Zellecken ein zusätzlicher Maskierungsschritt notwendig wird.

Eine weiteres Problem bei den genannten Transistoranordnungen ist die Realisierung einer Latch- und Kurzschlußfestigkeit. Eine Möglichkeit hierzu besteht darin, mit einer zusätzlichen Schaltung den maximal auftretenden Strom auf einen Wert zu begrenzen, bei dem das Bauelement noch sicher abgeschaltet werden kann. Dies ist beispielsweise in Z.J. Shen and S.P. Robb: A New Current Limit Circuit for Smart Discrete Devices, ISPSD '98, Kyoto 1998, S. 355 - 358 beschrieben. Diese Maßnahme erfordert jedoch einen erheblichen schaltungstechnischen Zusatzaufwand und begünstigt das Auftreten von Schwingungen.

In US 4,994,871 ist beschrieben, daß bei einem Trench-IGBT mit zusätzlichen p-Basis-Gebieten ohne Source oder teilweise Aussparung der Source der abschaltbare Strom erhöht werden kann. Nachteilig ist hierbei die absaugende Wirkung der zusätzlichen p-Gebiete, die im Durchlaßzustand die Trägerüberschwemmung verringern und damit die Durchlaßspannung erhöhen.

US 4,767,722 weist darauf hin, daß die Latch-up-Festigkeit eines Trench-IGBT durch schmale Source-Gebiete und damit einen reduzierten lateralen Basiswiderstand unterhalb der Source erhöht werden kann.

EP 0 633 611 und DE 2 801 085 offenbaren Feldeffekt-Transistoren mit grabenförmigen Gate-Elektroden und p-Basis-Gebieten, die aus unterschiedlich hoch dotierten Schichten bestehen.

Ein sehr geringer Abstand benachbarter Gate-Gräben und damit ein sehr hoher abschaltbarer Strom wird in EP 0 755 076 erreicht. Dabei wird der Anschluß des p-Basis-Gebietes an dem Kontakt durch ein p-Gebiet vermittelt, das höher als die Source dotiert und weniger tief eindiffundiert ist. Allerdings benötigt ein derartiger IGBT trotzdem eine Strombegrenzung, da die hohe Kanalweite einen viel zu großen Kurzschlußstrom zuläßt, der in kürzester Zeit zur thermischen Zerstörung des Bauelements führen würde.

Aufgabe der vorliegenden Erfindung ist es daher, eine Feldeffekt-Transistoranordnung bereitzustellen, bei der die genannten Probleme von grabenförmigen Gate-Elektroden weitgehend vermieden werden, sowie eine Möglichkeit zur Herstellung solcher Feldeffekt-Transistoranordnungen bereitzustellen.

Diese Aufgabe wird gelöst durch die Merkmale der Ansprüche 1 und 12.

Eine erste Ausführungsform der Erfindung betrifft eine Feldeffekt-Transistoranordnung mit einer grabenförmigen Gate-Elektrode, die sich in ein Substratgebiet ersten Leitungstyps erstreckt, wobei ein Sourcegebiet ersten Leitungstyps entlang des gesamten Grabens angeordnet ist und unter dem Sourcegebiet ein Bodygebiet zweiten Leitungstyps vorgesehen ist, das an das Sourcegebiet sowie an den Graben angrenzt. Es muß dabei jedoch nicht das gesamte Bodygebiet von dem Sourcegebiet bedeckt sein. Bevorzugt wird nur derjenige Teil des Bodygebietes von dem Sourcegebiet bedeckt, der an den Graben angrenzt.

Im Bodygebiet ist dabei ein hochdotierte Gebiet zweiten Leitungstyps vorgesehen, das zumindest teilweise unter dem Sourcegebiet angeordnet ist und dabei in vertikaler Richtung an das Sourcegebiet und in lateraler Richtung teilweise an den Graben angrenzt. Das hochdotierte Gebiet muß somit nicht ausschließlich unter dem Sourcegebiet angeordnet sein. Es kann vielmehr vorgesehen sein, daß sich gewisse Teile des hochdotierten Gebietes unter das Sourcegebiet erstrecken, der übrige Bereich des hochdotierten Gebietes jedoch in solchen Bereichen des Bodygebietes angeordnet ist, die nicht von einem Sourcegebiet bedeckt sind. Das hochdotierte Gebiet grenzt nicht entlang seines gesamten äußeren Randes, sondern nur in gewissen Teilbereichen an den Graben an, in dem die Gate-Elektrode ausgebildet ist.

Bekanntermaßen hängt die Einsatzspannung in der Kanalregion, die an der Grenze des Bodygebietes zum Gate-Graben gebildet wird, von der Dotierungskonzentration im Kanalgebiet ab. Somit führen die hochdotierten Gebiete zweiten Leitungstyps im Bodygebiet in denjenigen Bereichen zu einer wesentlich höheren Einsatzspannung als im übrigen Bodygebiet, in denen die hochdotierten Gebiete an den Gate-Graben angrenzen. Wird an das Bauelement nur eine Spannung angelegt, die geringer ist als diese erhöhte Einsatzspannung, so kann in den Bereichen, in denen die hochdotierten Gebiete an den Gate-Graben angrenzen, kein Kanal ausgebildet werden. Es kann damit erreicht werden, daß die Ausbildung eines Kanals im üblichen Betriebsbereich des Feldeffekt-Transistor lediglich im übrigen Bodygebiet, jedoch nicht im Bereich der hochdotierten Gebiete erfolgt. Man kann damit erreichen, daß besonders gefährdete Gebiete der Transistoranordnung stillgelegt werden können. Solche besonders gefährdeten Gebiete sind beispielsweise für den Fall einer Transistorzelle die Ecken der Zelle und/oder diejenigen Bereiche der Gräben, in denen die Ausrichtung der Grabenwand nicht einer Kristallebene entspricht, die der Kristallebene des Substrats mit den Millerindizes (100) äquivalent ist. Wie bereits aus EP 0 847 090 bekannt, kann es im Bereich von Zellecken zu unerwünscht frühem Einsetzen von Durchbruchsströmen kommen. Andererseits weist die Silizium/SiO₂-Grenzfläche an Kristallflächen, die nicht der Kristallebene (100) äquivalent sind, üblicherweise eine deutlich höhere Grenzflächenzustandsdichte auf als an solchen Flächen, die einer (100) Kristallebene äquivalent sind. Durch Veränderungen der Absättigung dieser Zustände im Laufe der Zeit ändert sich auch die Einsatzspannung eines dort gelegenen MOS-Kanals. Folge kann somit eine Instabilität der Einsatzspannung der Feldeffekt-Transistoranordnung sein. Durch eine Anordnung nach der ersten Ausführungsform der vorliegenden Erfindung können diese Probleme vermieden werden.

Die vorliegende Erfindung ermöglicht es somit, in allen Bereichen der Transistoranordnung die Ausbildung eines Kanals bei üblichen Betriebsbereichen zu verhindern, in denen dieses unerwünscht oder kritisch erscheint.

Außerdem bietet das hochdotierte Gebiet im Bodygebiet den Vorteil einer Erhöhung der Leitfähigkeit im Bodygebiet unter der Source. Somit kann insbesondere beim Abschaltvorgang dafür gesorgt werden, daß Ladungsträger wesentlich leichter aus dem Bodygebiet abtransportiert werden. Damit kann vermieden werden, daß gerade beim Abschalten ein Spannungsabfall im Bodygebiet gegenüber dem Sourcegebiet entsteht, der zum Einschalten eines parasitären Bipolartransistors aus Source, Bodygebiet und Draingebiet führt und damit ein Latch-up der Anordnung zur Folge hätte. Hochdotierte Gebiete im Bereich des Bodygebietes sind zwar prinzipiell aus US 5,689,128 oder US 5,821,583 bekannt, die dort beschriebenen Anordnungen unterscheiden sich jedoch deutlich vom Gegenstand der vorliegenden Erfindung.

Die erste Ausführungsform der vorliegenden Erfindung weist sowohl die Eigenschaften der Verhinderung einer Kanalausbildung in gewissen Bereichen des Gate-Grabens auf, als auch die Möglichkeit einer Verbesserung der Leitfähigkeit im Bodygebiet.

Die Transistoranordnung kann als Transistorzelle ausgebildet sein, die mindestens zwei sich kreuzende Gate-Gräben aufweist. So kann beispielsweise vorgesehen werden, daß die Transistorzelle als geschlossene Zelle ausgebildet ist, die allseitig von Gräben umgeben ist. Die Gräben können dabei z.B. in ihren Endpunkten in einem rechten Winkel zueinander stehen und somit eine rechteckige Zelle bilden. Es sind jedoch auch beispielsweise sechseckige Zellen oder beliebige andere Anordnungen in Zellenform möglich.

Für die erste Ausführungsform der vorliegenden Erfindung muß das hochdotierte Gebiet sich nicht notwendigerweise über die gesamte Fläche der Transistorzelle bzw. bis zur Mitte der Transistorzelle erstrecken. Es kann ausreichen, lediglich in den Bereichen ein hochdotiertes Gebiet vorzusehen, in denen der Kanal der Transistorzelle stillgelegt werden soll. Soll jedoch zusätzlich auch eine möglichst gute Leitfähigkeit im Bodygebiet erzielt werden, so kann das hochdotierte Gebiet bei der ersten Ausführungsform entsprechend größer ausgebildet werden und sich über weitere Bereich des Bodygebietes erstrecken. Insbesondere kann vorgesehen werden, daß sich das hochdotierte Gebiet bis zur Kontaktierung des Bodygebietes erstreckt.

Gemäß der Erfindung kann damit das hochdotierte Gebiet mit einer Kontaktierung des Bodygebietes und des Sourcegebietes verbunden werden. Die Kontaktierung kann dabei als Grabenkontakt ausgebildet werden, der sich durch das Sourcegebiet bis hin zum Bodygebiet erstreckt.

Gemäß der Erfindung kann eine Anpassung der Kanalweite erfolgen, so daß vor allem der im Kurzschlußfall auftretende Kurzschlußstrom begrenzt werden kann. Dabei kann sowohl eine Anpassung der Kanalweite pro Transistorzelle als auch ein Anpassung der Kanalweite pro Fläche erfolgen. Eine Anpassung pro Transistorzelle kann durch Stillegen von Bereichen der Kanalregion erfolgen, sei es durch ein p+-Gebiet, das an den Graben angrenzt oder durch ein zurückgesetztes Sourcegebiet. Die Anpassung pro Fläche kann durch eine entsprechende Distanz zwischen den einzelnen Transistorzellen der gesamten Struktur erfolgen, d.h. es werden pro Fläche weniger Transistorzellen vorgesehen. Die Gate-Gräben der Transistorzellen können dabei durch Verbindungsgräben untereinander verbunden sein, die jedoch so ausgebildet werden, daß sie nicht zur Ausbildung eines Kanals beitragen, d.h. es grenzen keine Kanalgebiete eines Bodygebietes an diese Verbindungsgräben an, in denen ein Kanal entstehen könnte. Die Kanalweite pro Fläche wird somit durch die Verbindungsgräben nicht beeinflußt. Es kann jedoch auch auf eine Verbindung der einzelnen Transistorzellen untereinander durch Verbindungsgräben verzichtet werden.

Die vorliegende Erfindung kann bei allen Arten von Feldeffekt-Transistoranordnungen Anwendung finden. Insbesondere kann diese bei MOSFET-Transistoren angewendet werden. Sie kann jedoch auch bei einer Transistoranordnung verwendet werden, die eine Anodenzone zweiten Leitungstyps aufweist, die an die Drainzone angrenzt. Dies trifft insbesondere für eine IGBT-Anordnung zu.

Im folgenden werden Verfahren zur Herstellung von Body- und Sourcegebiet einer Feldeffekt-Transistoranordnungen beschrieben. Das folgende Verfahren kann dabei insbesondere zur Herstellung einer Feldeffekt-Transistoranordnung nach Anspruch 1 verwendet werden.

Die Herstellung der Gate-Elektroden der Transistoranordnung kann dabei nach üblichen Verfahren erfolgen: In eine erste Oberfläche erfolgt eine Strukturierung von mindestens zwei sich kreuzenden Gräben in das Substrat. Je nach Anordnung der Gräben kann damit erreicht werden, daß eine Transistorzelle gebildet wird, die speziell als geschlossene Zelle, d. h. allseitig von Gräben umgeben, ausgebildet sein kann. Die Bildung dieser Gräben kann dabei vor der Erzeugung des Bodygebietes und des Sourcegebietes der Transistorzelle erfolgen, sie kann aber beispielsweise auch erst nach der Bildung des Bodygebietes erfolgen oder nach der Bildung des Bodygebietes und des Sourcegebietes.Werden die Gräben erst nach Bildung des Bodygebietes bzw. des Sourcegebietes erzeugt, so ist bei der Anordnung dieser Gebiete darauf zu achten, daß sie bereits in richtigen Weise orientiert werden, um nach Strukturierung der Gräben beispielsweise ein Angrenzen an die Gräben zu gewährleisten.

Die Gräben werden mit einer Isolationsschicht ausgekleidet, die die inneren Wände der Gräben bedeckt. Dies kann beispielsweise durch eine Oxidation oder Nitrierung der Grabenwände oder durch eine Abscheidung isolierenden Materials erfolgen

Anschließend erfolgt ein Auffüllen der Gräben mit einem Leitungsmaterial. Hierbei kann prinzipiell jede Art von Leitungsmaterial Verwendung finden, wobei bevorzugt als Leitungsmaterial Polysilizium verwendet wird.

Das erfindungsgemäße Verfahren umfaßt folgende Schritte:
Es wird ein Substrat ersten Leitungstyps bereitgestellt, wobei die weiteren Strukturierungsschritte hauptsächlich von einer ersten Oberfläche des Substrats ausgehen.

In dem bereitgestellten Substrat wird ein Bodygebiet zweiten Leitungstyps erzeugt, wobei dieser zweite Leitungstyp dem ersten Leitungstyp entgegengesetzt ist, so daß das Bodygebiet nach Erzeugung der Gräben an die Gräben angrenzt. Wurde anfangs ein n-leitendes Substrat verwendet, so weist nun das Bodygebiet einen p-Leitungstyp auf. Es kann natürlich auch von einem p-leitendem Substrat ausgegangen werden, wobei dann das Bodygebiet einen n-Leitungstyp aufweist. Das Bodygebiet wird bevorzugt so erzeugt, daß es nach Erzeugung der Gräben auf der gesamten Länge der Gräben an diese Gräben angrenzt. Sofern dies jedoch erforderlich ist, kann auch vorgesehen werden, daß das Bodygebiet nach Erzeugung der Gräben in bestimmten Bereichen von den Gräben zurückgesetzt angeordnet ist.

Anschließend erfolgt die Bildung eines hochdotierten Gebietes zweiten Leitungstyps im oberen Bereich des Bodygebietes, so daß das hochdotierte Gebiet nach Erzeugung der Gräben lateral nur teilweise an die Gräben angrenzt. Das hochdotierte Gebiet erstreckt sich somit nicht über die gesamte Ausdehnung des Bodygebietes, sondern es ist nur in gewissen Bereichen des Bodygebietes vorgesehen. Insbesondere grenzt das hochdotierte Gebiet nur in gewissen Bereichen direkt an die Gräben an, in den übrigen Bereichen ist das hochdotierte Gebiet von den Gräben zurückgesetzt angeordnet. Das hochdotierte Gebiet wird erzeugt, indem Dotiermäterial zweiten Leitungstyps in höherer Konzentration in das bereits vorhandene Bodygebiet mit niedrigerer Konzentration an Dotiermaterial eingebracht wird. Die Verteilung des Dotiermaterials höherer Konzentration im Bodygebiet wird durch die Verwendung entsprechender Masken bei der Einbringung des Dotiermaterials gesteuert.

Es erfolgt die Bildung eines Sourcegebietes ersten Leitungstyps über dem Bodygebiet, wobei das Sourcegebiet nach Erzeugung der Gräben in gesamter Länge an die Gräben angrenzt und sich von der Oberfläche des Substrats aus in das Substrat erstreckt. Das Sourcegebiet wird bis in eine solche Tiefe in das Substrat eingebracht, daß es an das Bodygebiet und an das hochdotierte Gebiet angrenzt.

Es kann bevorzugt vorgesehen sein, daß bei der Bildung des Bodygebietes und des hochdotierten Gebietes sich diese Gebiete ebenfalls zunächst von der Oberfläche des Substrats aus in das Substrat erstrecken. Das Sourcegebiet wird dann durch Einbringen eines Dotiermaterials ersten Leitungstyps von der Oberfläche des Substrats aus erzeugt, wobei das Dotiermaterial für das Sourcegebiet mit einer höheren Dotierungskonzentration eingebracht wird als der Dotierungskonzentration des Bodygebietes und des hochdotierten Gebietes. Somit wird in denjenigen Bereichen des Bodygebietes und des hochdotierten Gebietes, in die das Dotiermaterial ersten Leitungstyps zur Erzeugung des Sourcegebietes eingebracht wird, das Bodygebiet bzw. das hochdotierte Gebiet umdotiert und es dominiert das Dotiermaterial ersten Leitungstyps des Sourcegebietes. Das Dotiermaterial des Sourcegebietes wird dabei mit einer geringeren Eindringtiefe in das Substrat eingebracht als die Tiefe des Bodygebietes und des hochdotierten Gebietes.

Es kann nach der Erzeugung des Sourcegebietes vorgesehen werden, daß ein Grabenkontakt durch das Sourcegebiet strukturiert wird, der bis zum Bodygebiet reicht und für eine Kontaktierung des Bodygebietes und dabei auch des hochdotierten Gebietes genutzt werden kann.

Bei dem beschriebenen Verfahren erfolgt anschließend die übliche weitere Prozessierung der Transistoranordnung, wie beispielsweise Aufbringung von Metallisierungen oder für den Fall eines IGBT Erzeugung einer Anodenzone zweiten Leitungstyps. Diese weiteren Schritte sind aus dem Stand der Technik hinreichend bekannt. Ebenso sind aus dem Stand der Technik übliche Prozeßschritte wie beispielsweise die Verwendung eines p⁺-Substrates mit Epitaxieschichten für n-Buffer und n⁻-Basis als Ausgangsmaterial für einen IGBT bzw. die Verwendung eines n⁺-Substrates mit n⁻-Epitaxieschicht für einen Leistungs-MOSFET bekannt.

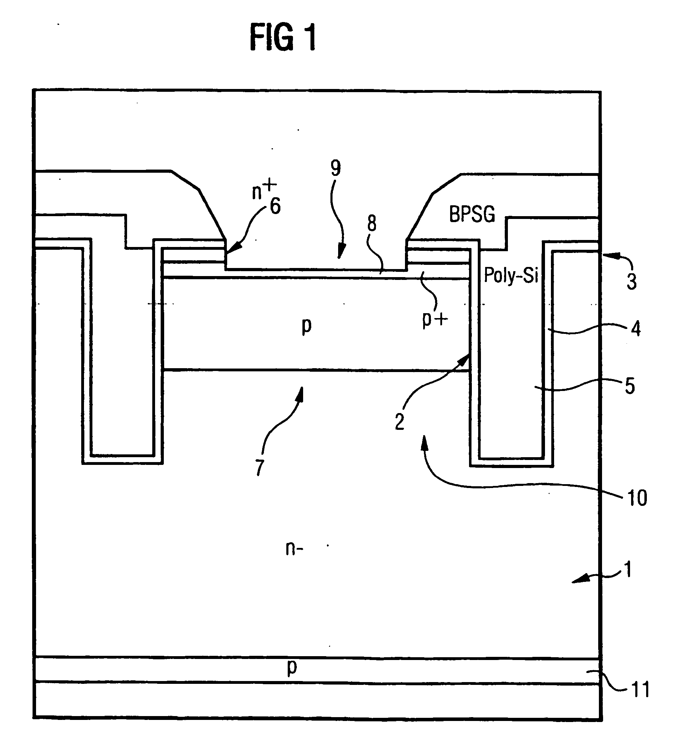

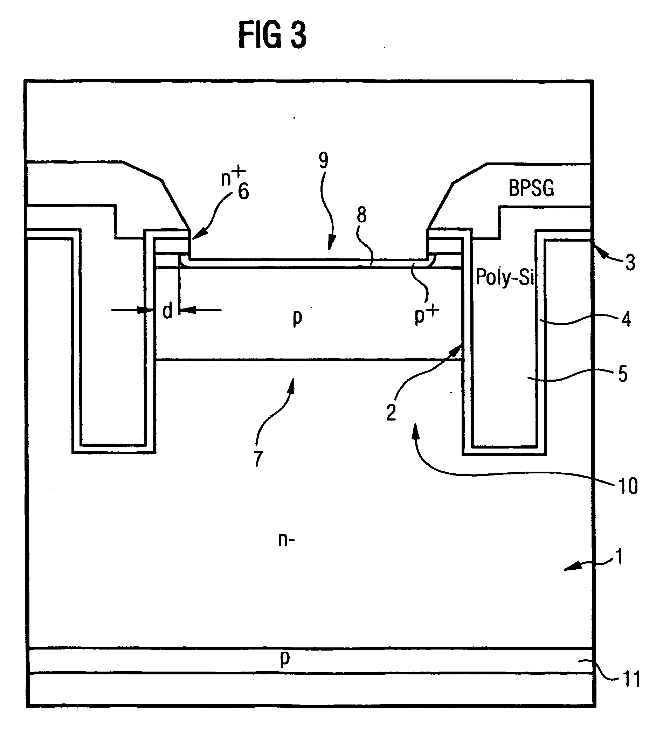

Spezielle Ausführungsbeispiele der vorliegenden Erfindung werden anhand der Figuren 1, 2, 7 und 8 sowie der nachfolgenden zugehörigen Beschreibung erläutert. Die Figuren 3 bis 6 zeigen keine Ausführungsbeispiele der Erfindung, sondern Beispiele, die das Verständnis der Erfindung erleichtern sollen.

Es zeigen
- Figur 1:: IGBT mit grabenförmiger Gate-Elektrode und hochdotiertem Gebiet im Bodygebiet, das im Bereich des gezeigten Querschnitts an den Gate-Graben angrenzt.
- Figur 2:: Aufsicht auf eine Anordnung nach Figur 1, wobei das hochdotierte Gebiet in den Ecken an den Graben an grenzt.
- Figur 3:: IGBT mit grabenförmiger Gate-Elektrode und hochdotiertem Gebiet im Bodygebiet, das durch die Kontaktöffnung eingebracht wurde
- Figur 4:: Anordnung wie Figur 3, jedoch mit hochdotiertem Ge biet, das unabhängig vom Kontaktloch eingebracht wurde.
- Figur 5:: Draufsicht auf eine Anordnung nach Figur 3 oder Figur 4.
- Figur 6:: Anordnung wie Figur 5, jedoch mit Aussparung der Source in den Ecken der Zelle.
- Figur 7:: a) Anordnung der Transistorzelle bei Ausrichtung des Wafers entlang einer (100)-äquivalenten Kristallebene.
b) Anordnung der Transistorzelle bei Ausrichtung des Wafers entlang einer (110)-äquivalenten Kristallebene.
- Figur 8:: Beispiele für Zellenanordnungen
a) quadratisches Zellenmuster aus Gate-Gräben
b) isolierte quadratische Zellen
c) quadratische Zellen mit Verbindungsgräben
d) wie c), jedoch mit Verbindungen über die
Zellecken

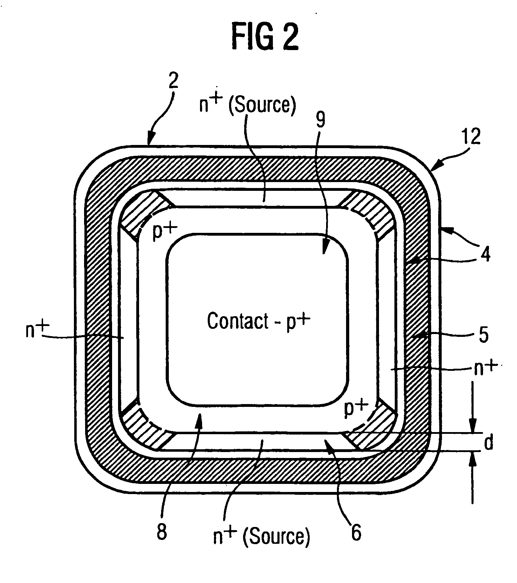

Figur 1 zeigt einen Trench-IGBT, d. h. einen IGBT mit grabenförmigen Gate-Elektroden. Sourcegebiet 6 und Bodygebiet 7 sind dabei jeweils zwischen zwei Gräben 2 angeordnet. Die Gräben 2 können dabei eine Transistorzelle 12 bilden, wie in einem Beispiel in Figur 2 gezeigt wird. Die Transistorzelle 12 in Figur 2 ist in quadratischer Form ausgebildet, die von einem geschlossenen Graben 2 umgeben ist. Es können natürlich auch andere Formen für die Transistorzelle 12 vorgesehen werden, wie beispielsweise rechteckig oder sechseckig.

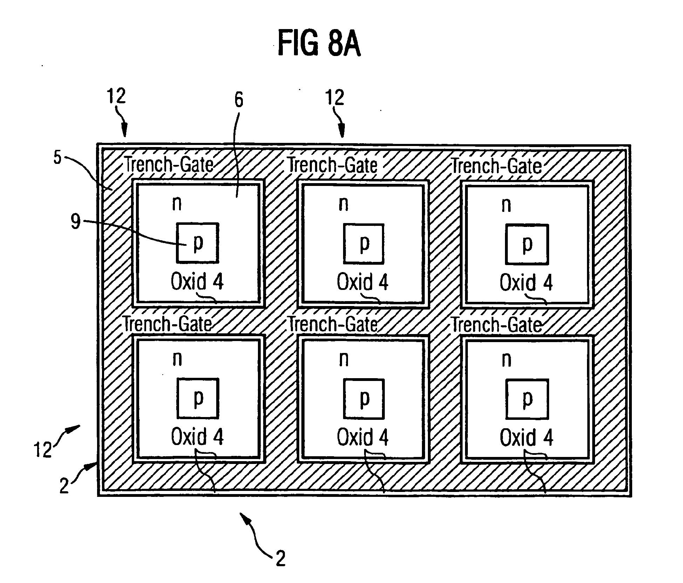

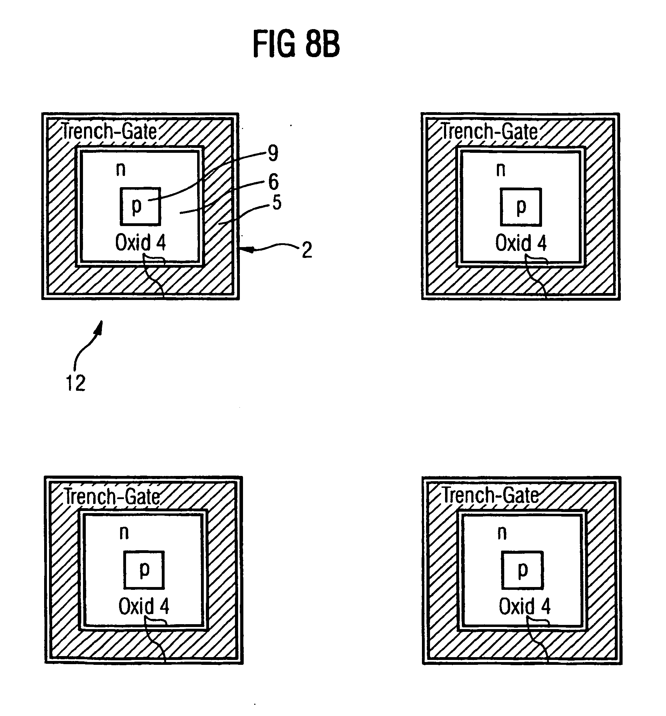

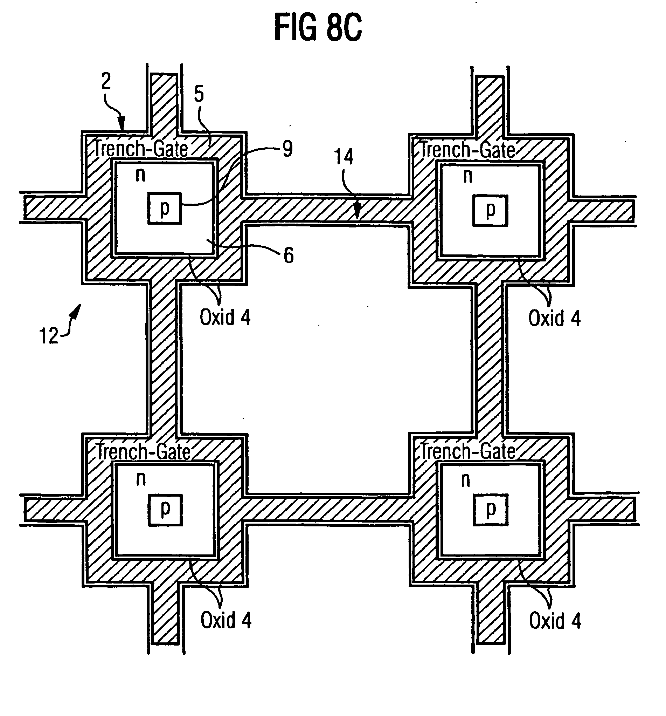

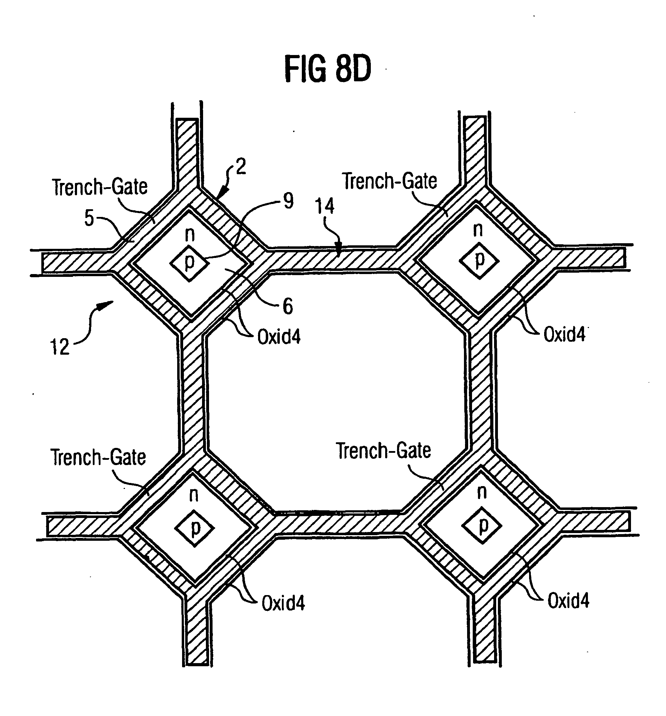

Es können verschiedene Anordnungen der Transistorzellen 12 zu einem gesamten Zellenmuster vorgesehen sein. Einige Beispiele hierzu sind in den Figuren 8 a) bis d) dargestellt. So können mehrere oder alle Transistorzellen 12 untereinander verbunden sein, wobei die geschlossenen Gate-Grabenstrukturen 2 durch Verbindungsgräben 14 miteinander verbunden werden können oder die Zellen wie in Fig. 8a) direkt aneinander angrenzen und somit durch gemeinsame Gate-Gräben 2 miteinander verbunden sind. Im Falle von Figur 8a) wird auf beiden Seiten der Gate-Gräben 2, die zwei Zellen 12 verbinden, ein Kanalgebiet erzeugt. Für die Fälle der Figuren 8 c) und d) wird nur auf einer Seite eines Gate-Grabens 2 ein Kanalgebiet erzeugt, entlang der Verbindungsgräben 14 entstehen keine Kanalgebiete. Es können jedoch auch die Zellen völlig getrennt voneinander angeordnet sein, wie in Figur 8 b) dargestellt.

Die Gate-Gräben 2 erstrecken sich von einer Oberfläche 3 des Substrats 1 aus in das Substrat 1 hinein und sind mit einer Isolationsschicht 4 ausgekleidet, die beispielsweise aus Siliziumoxid bestehen kann. Die Gräben 2 sind gefüllt mit einem Leitungsmaterial 5, das beispielsweise aus Polysilizium bestehen kann. Die Sourcegebiete 6, die eine Dotierung von Typ n⁺ aufweisen, grenzen auf der gesamten Länge der Gräben 2 an diese Gate-Gräben 2 an. Unter den Sourcegebieten 6 ist das Bodygebiet 7 angeordnet, das eine Dotierung vom Typ p aufweist. Im oberen Teil des Bodygebietes, das an die Source angrenzt, ist ein hochdotiertes p⁺-Gebiet 8 vorgesehen.

Das hochdotierte Gebiet 8 grenzt vertikal direkt an die Source 6 an, wobei es jedoch lateral nur in Teilbereichen an die Gate-Gräben 2 angrenzt. In Figur 2 ist dargestellt, daß das hochdotierte Gebiet 8 lediglich in den Ecken der Transistorzelle 12 an die Gräben 2 angrenzt. In den übrigen Bereichen ist das hochdotierte Gebiet 8 von den Gräben zurückgesetzt angeordnet. Die schraffierten Gebiete in den Zellecken in Figur 2 sollen andeuten, daß das Sourcegebiet 6 sich auch bis in die Ecken der Transistorzelle erstreckt und in diesen Bereichen über dem hochdotierten Gebiet 8 angeordnet ist. Das Sourcegebiet 6 erstreckt sich somit entlang der gesamten Länge der Gräben 2. Fig. 1 entspricht also beispielsweise einem diagonalen Schnitt durch zwei Ecken der Fig. 2.

In den Ecken der Transistorzelle, in denen das hochdotierte Gebiet 8 direkt an die Gräben angrenzt und von dem Sourcegebiet 6 überdeckt wird, wird die Einsatzspannung für einen Kanal hauptsächlich von der Dotierung des hochdotierten Gebietes 8 bestimmt. Diese Einsatzspannung ist höher als die Einsatzspannung für die übrigen Bereiche, in denen sich der Kanal an der Grenze des Bodygebietes 7 zu den Gräben 2 ausbildet. Dort wird die Einsatzspannung durch die niedrigere Konzentration des Bodygebietes 7 bestimmt und ist somit niedriger als in den Ecken der Transistorzelle 12. Durch entsprechende Wahl der Dotierung des hochdotierten Gebietes 8 und der Betriebsbereiche der Transistorzelle 12 kann somit erreicht werden, dass die Einsatzspannung in den Ecken der Transistorzelle 12 nicht erreicht wird und es in diesen Bereichen der Transistorzelle nicht zur Ausbildung eines Kanals kommen kann.

Die Kontaktierung des Bodygebietes 7 und des hochdotierten Gebietes 8 erfolgt über einen Grabenkontakt 9, der mit leitendem Material gefüllt wird. Durch diesen Grabenkontakt wird auch gleichzeitig das Sourcegebiet mit dem Bodygebiet und dem hochdotierten Gebiet leitend verbunden. Damit kann die Wirkung von Sourcegebiet 6 und Bodygebiet 7 bzw. hochdotiertem Gebiet 8 als Teil eines parasitären npn-Transistors weitgehend vermieden werden.

Auf der gegenüberliegenden Seite des Substrats 1 wird noch eine p-dotierte Schicht als Anodenzone 11 vorgesehen.

Die Dicke der hochdotierten Schicht 8 nach Figur 1 kann prinzipiell beliebig gewählt werden. Es muß lediglich erzielt werden können, dass in denjenigen Gebieten, in denen die hoch- dotierte Schicht 8 an den Graben 2 angrenzt, die Einsatzspannung wesentlich heraufgesetzt wird. In einer speziellen Ausführungsform kann die hochdotierte Schicht 8 jedoch relativ dünn im Vergleich zum Bodygebiet 7 gewählt werden. Hierbei kann vorgesehen werden, dass die Dicke des hochdotierten Gebietes 8 maximal 1/3 der Dicke des Bodygebietes 7 beträgt, idealerweise nur maximal 20% der Dicke des Bodygebietes 7. So kann beispielsweise das Bodygebiet eine Dicke von 1 µm bis etwa 3 µm aufweisen, die Dicke des hochdotierten Gebietes 8 Werte von 0,2 µm bis etwa 1 µm betragen.

Figur 3 zeigt zur Veranschaulichung einen IGBT. Dieser IGBT entspricht im wesentlichen dem Ausführungsbeispiel nach Figur 1. Wesentlicher Unterschied ist jedoch, dass sich das hochdotierte Gebiet 8 nicht bis zu den Gräben 2 erstreckt. Das hochdotierte Gebiet 8 ist um einen gewissen Abstand d von den Gräben 2 zurückgesetzt angeordnet. Das hochdotierte Gebiet 8 wird dabei als relativ dünne Schicht vorgesehen, die ebenfalls lediglich 1/3 der Dicke des Bodygebietes 7 aufweist, idealerweise maximal 20% der Dicke des Bodygebietes. Das hochdotierte Gebiet ist dabei als Schicht mit weitgehend gleichmäßiger Dicke entlang des Grabenkontaktes 9 ausgebildet und kann z.B. durch Implantation in das Kontaktloch erzeugt werden.

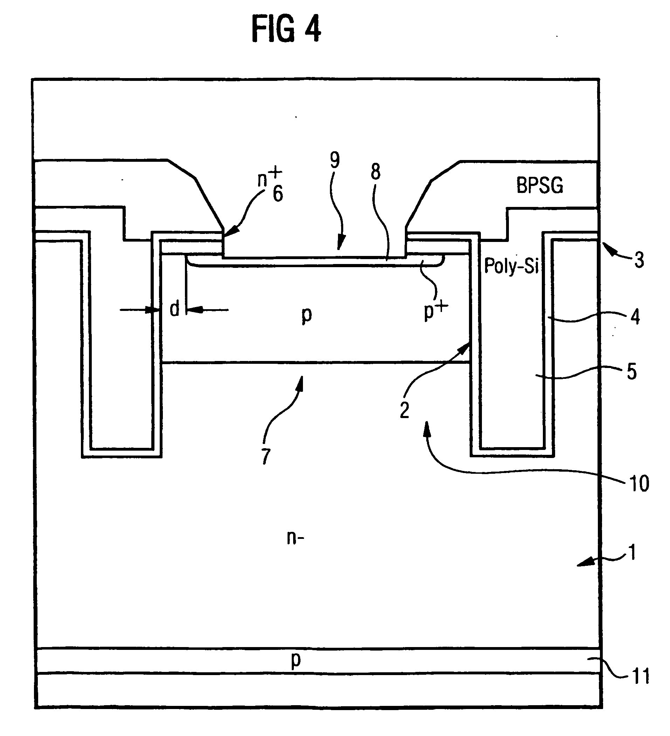

Figur 4 zeigt zur Veranschaulichung eine alternative Ausführungsform zu Figur 3, wobei ein kleineres Kontaktloch 9 vorgesehen ist. Dies ist sinnvoll, wenn die Gefahr gegeben ist, dass aufgrund der topographischen Struktur bei geringen Verjustierungen während der Strukturierung der Anordnung ein Kurzschluß zwischen dem Kontaktmetall zur Source- und Bodykontaktierung und der Gate-Elektrode 5 entstehen kann. Eine Verringerung der Größe des Kontaktloches 9 bringt hier zusätzliche Sicherheit. In diesem Fall wird vorgesehen, dass das hochdotierte Gebiet 8 nicht durch das Kontaktloch 9 eingebracht wird, sondern durch eine gesonderte Lackmaske strukturiert wird und bereits vor der Erzeugung des Kontaktloches in das Bodygebiet eingebracht wird. Hierbei kann auch die laterale und vertikale Ausdehnung des hochdotierten Gebietes 8 unterschiedlich gestaltet werden. So kann beispielsweise, wie in Fig. 4 angedeutet, das hochdotierte Gebiet in lateraler Richtung eine größere Ausdehnung aufweisen als in vertikaler Richtung. Damit wird einerseits die Leitfähigkeit im Bodygebiet 7 in lateraler Richtung wesentlich verbessert. Der übrige Teil des Bodygebietes 7 bleibt jedoch durch die geringe vertikale Ausdehnung des hochdotierten Gebietes 8 weitgehend unbeeinflußt. Andererseits kann der Abstand d zum Graben 2 relativ einfach variiert werden und somit die Wirkung der hochdotierten Schicht 8 auch in der Nähe des Grabens 2 beeinflußt werden.

Der Abstand d zwischen dem hochdotierten Gebiet 8 und dem Gate-Graben 2 wird in beiden Ausführungsbeispielen kleiner als 1 µm, vorzugsweise kleiner als 0,7 µm gewählt.

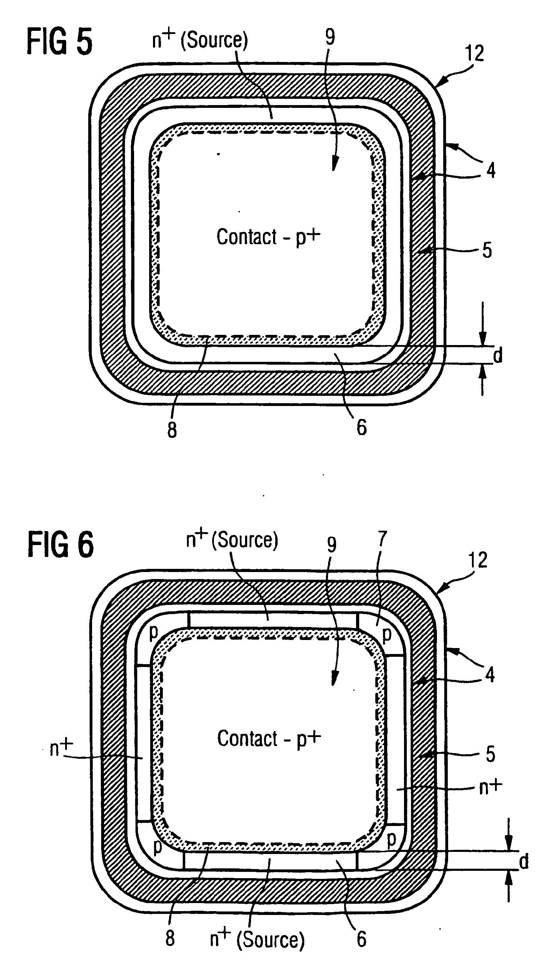

Figur 5 zeigt eine Draufsicht auf eine veranschaulichende Anordnung nach Figur 3 oder 4, wobei derjenige Bereich des hochdotierten Gebietes 8, der von der Source 6 überdeckt wird, durch eine schraffierte Fläche dargestellt wird.

Figur 6 entspricht der Darstellung von Figur 5, wobei jedoch in den Ecken der Transistorzelle 12 die Sourcegebiete 6 ausgespart sind, d. h., dass im Bereich der Ecken die Source von den Gräben 2 zurückgesetzt angeordnet ist. Dies kann durch entsprechende Maskierungsschritte während des Herstellungsverfahrens erzielt werden. Auf diese Weise kann in den Ecken der Transistorzelle 12 die Ausbildung eines Kanals verhindert werden.

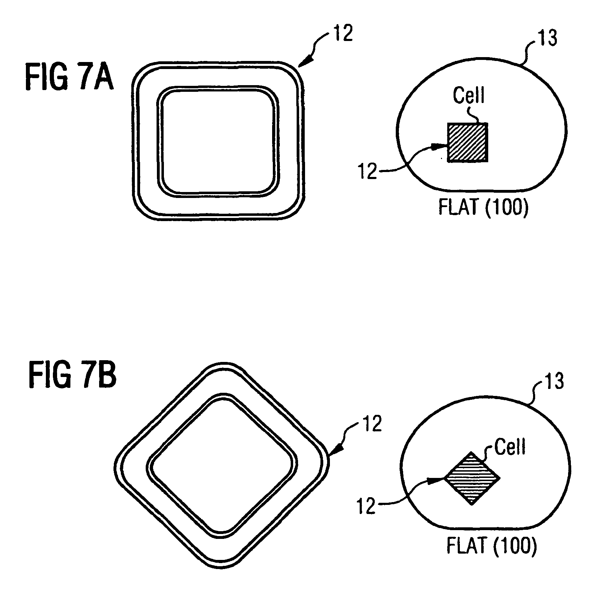

Figuren 7a und b veranschaulichen die Ausrichtung einer Transistorzelle in einer bevorzugten Ausführungsform auf einem Wafer. Es wird in beiden Fällen von einer viereckigen, in der Darstellung von einer quadratischen Transistorzelle ausgegangen. Bei der Ausrichtung der Transistorzelle auf dem Wafer soll berücksichtigt werden, dass ein möglichst großer Teil der Transistorzelle 12 so angeordnet wird, dass negative Einflüsse in Bezug auf die Wirkungsweise der Transistorzelle, insbesondere in Bezug auf die Kanalbildung und Einsatzspannung, verhindert werden können.

In Figur 7a weist der Wafer 13 eine Ausrichtung entlang einer Kristallebene auf, die der (100)-Kristallebene äquivalent ist. In diesem Fall erfolgt die Ausrichtung der Transistorzelle 12 so, dass die Seiten der Transistorzelle 12 entweder entlang der Hauptrichtung des Wafers 13 oder in einem Winkel von 90° zu dieser Hauptrichtung ausgerichtet sind. Man erzielt damit eine Ausrichtung der Seiten der Transistorzelle entlang einer Ebene, die der (100)-Ebene des Substrats äquivalent ist.

Im Fall der Figur 7b wurde der Wafer entlang einer (110)-äquivalenten Kristallebene ausgerichtet. In diesem Fall werden die Seiten der Transistorzelle in einem Winkel von 45° zur Hauptrichtung des Wafers 13 angeordnet. Man erzielt damit wiederum eine Ausrichtung der Seiten entlang einer Kristallebene, die der (100)-Kristallebene des Substrats äquivalent ist.

In beiden Fällen wird erzielt, daß der größtmögliche Teil der Seiten der Transistorzelle, d. h. der größtmögliche Teil der Gate-Gräben 2, entlang einer (100)-äquivalenten Kristallebene orientiert ist. Lediglich in den Ecken der Transistorzelle 12 sind somit die Seitenwände der Gräben 2 entlang von Kristallebenen orientiert, die nicht der Kristallebene (100) entsprechen. Damit können störende Einflüsse, die aus Schwankungen der Grenzflächen-Zustandsdichten an den unterschiedlich orientierten Kristallebenen resultieren, weitgehend vermieden werden.

Die Anordnung vieler Transistorzellen 12 auf einem Wafer 13 kann dabei in einem beispielsweise quadratischen Muster erfolgen, wobei die Gate-Elektroden 5 in den Gräben 2 untereinander durch weitere Gräben verbunden sein können. Beispiele von Anordnungen der Transistorzellen 12 sind in den Figuren 8 a) bis d) dargestellt.

## Patentansprüche

1. Feldeffekt-Transistoranordnung mit einer grabenförmigen Gate-Elektrode mit
- einem Substratgebiet (1) ersten Leitungstyps,
- mindestens einem Graben (2), der sich von einer ersten Oberfläche (3) des Substrats (1) aus in das Substrat (1) erstreckt,
- einer Isolationsschicht (4), die die Wände des mindestens einen Grabens (2) bedeckt,
- einem Leitungsmaterial (5), das den Graben (2) ausfüllt und eine Gate-Elektrode bildet,
- einem Sourcegebiet (6) ersten Leitungstyps, das entlang des Grabens (2) angeordnet ist und sich von der ersten Oberfläche (3) des Substrats (1) aus in das Substrat (1) erstreckt,
- einem Bodygebiet (7) zweiten Leitungstyps, welcher zum ersten Leitungstyp entgegengesetzt ist, wobei sich das Bodygebiet (7) unter das Sourcegebiet (6) erstreckt und dabei in vertikaler Richtung an das Sourcegebiet und in lateraler Richtung an den Graben (2) angrenzt,
- einem Draingebiet (10) ersten Leitungstyps, das an das Bodygebiet (7) angrenzt,
- mindestens einem hochdotierten Gebiet (8) zweiten Leitungstyps im Bodygebiet (7), wobei das hochdotierte Gebiet (8) zumindest teilsweise unter dem Sourcegebiet (6) angeordnet ist und dabei an das Sourcegebiet (6) angrenzt,
**dadurch gekennzeichnet,**
**dass** das hochdotierte Gebiet (8) lateral nur in Teilbereichen, und nicht entlang seines gesamten äußeren Randes, an den Graben (2) angrenzt, so dass die Einsatzspannung in diesen Teilbereichen höher ist als in den übrigen Bereichen des Bodygebiets (7).

2. Transistoranordnung nach Anspruch 1,
**dadurch gekennzeichnet,**
**daß** die Dicke des hochdotierten Gebietes (8) maximal ein Drittel der Dicke des Bodygebietes (7) beträgt.

3. Transistoranordnung nach Anspruch 1 oder 2,
**dadurch gekennzeichnet,**
**daß** die Dicke des hochdotierten Gebietes (8) maximal 20 % der Dicke des Bodygebietes (7) beträgt.

4. Transistoranordnung nach einem der Ansprüche 1 bis 3,
**dadurch gekennzeichnet,**
**daß** die Transistoranordnung als Transistorzelle ausgebildet ist, die mindestens zwei sich kreuzende Gräben (2) aufweist.

5. Transistoranordnung nach Anspruch 4,
**dadurch gekennzeichnet,**
**daß** das mindestens eine hochdotierte Gebiet (8) in gewissen Bereichen der Gräben (2) an diese angrenzt, die zumindest diejenigen Bereiche umfassen, in denen die Ausrichtung der Grabenwand nicht einer Kristallebene entspricht, die der (100)-Kristallebene des Substrats (1) äquivalent ist und
im übrigen Bereich der Gräben (2) von den Gräben (2) zurückgesetzt angeordnet ist.

6. Transistoranordnung nach einem der Ansprüche 4 oder 5,
**dadurch gekennzeichnet,**
**daß** das mindestens eine hochdotierte Gebiet (8) in gewissen Bereichen der Gräben (2) an diese angrenzt, die zumindest die Ecken der Transistorzelle umfassen, welche durch die Kreuzung zweier Gräben (2) gebildet werden und
im übrigen Bereich der Gräben (2) von den Gräben (2) zurückgesetzt angeordnet ist.

7. Transistoranordnung nach einem der Ansprüche 5 oder 6,
**dadurch gekennzeichnet,**
**daß** der Abstand des hochdotierten Gebietes (8) von den Gräben (2) in den übrigen Bereichen, in denen das hochdotierte Gebiet (8) von den Gräben (2) zurückgesetzt angeordnet ist, maximal 1 µm beträgt.

8. Transistoranordnung nach einem der Ansprüche 4 bis 7,
**dadurch gekennzeichnet,**
**daß** die Transistorzelle als geschlossene Zelle ausgebildet ist, die allseitig von Gräben (2) umgeben ist, und
sich das mindestens eine hochdotierte Gebiet (8) von den Zellecken zur Mitte der Transistorzelle erstreckt.

9. Transistoranordnung nach einem der Ansprüche 1 bis 8,
**dadurch gekennzeichnet,**
**daß** das mindestens eine hochdotierte Gebiet (8) mit einer Kontaktierung (9) des Bodygebietes (7) und des Sourcegebietes (6) verbunden ist.

10. Transistoranordnung nach Anspruch 9,
**dadurch gekennzeichnet,**
**dass** die Kontaktierung (9) als Grabenkontakt ausgebildet ist, der sich durch das Sourcegebiet (6) bis zum hochdotierten Gebiet (8) erstreckt.

11. Transistoranordnung nach einem der Ansprüche 1 bis 10,
**dadurch gekennzeichnet,**
**daß** die Transistoranordnung eine Anodenzone (11) zweiten Leitungstyps aufweist, die an die Drainzone (10) angrenzt.

12. Verfahren zur Herstellung eines Bodygebietes und eines Sourcegebietes einer Feldeffekt-Transistorzelle mit einer grabenförmigen Gate-Elektrode, mit den Schritten:
- Bereitstellen eines Substrats (1) ersten Leitungstyps mit einer ersten Oberfläche (3),
- Erzeugung von Gräben (2), die sich von der ersten Oberfläche (3) des Substrats (1) aus in das Substrat (1) erstrecken,
- Bedecken der Wände der Gräben (2) mit einer Isolationsschicht (4),
- Auffüllen der Gräben (2) mit einem Leitungsmaterial (5) zur Bildung der Gate-Elektrode,
- Bilden eines Bodygebiets (7) zweiten Leitungstyps, der zum ersten Leitungstyp entgegengesetzt ist, in dem Substrat (1), so daß das Bodygebiet (7) nach Erzeugung der Gräben (2) an die Gräben (2) angrenzt,
- Bilden eines hochdotierten Gebietes (8) zweiten Leitungstyps im oberen Bereich des Bodygebietes (7),
- Bildung eines Sourcegebietes (6) ersten Leitungstyps über dem Bodygebiet (7), das in vertikaler Richtung an das Bodygebiet und nach Erzeugung der Gräben (2) in lateraler Richtung an die Gräben (2) angrenzt und sich von der Oberfläche (3) des Substrats (1) aus in das Substrat (1) erstreckt,
**dadurch gekennzeichnet,**
**dass** das hochdotierte Gebiet (8) nach der Erzeugung der Gräben (2) lateral nur in Teilbereichen, und nicht entlang seines gesamten äußeren Randes, an die Gräben (2) angrenzt, so dass die Einsatzspannung in diesen Teilbereichen höher ist als in den übrigen Bereichen des Bodygebiets.

13. Verfahren nach Anspruch 12,
**dadurch gekennzeichnet,**
**daß** zunächst das Bodygebiet (7) und das hochdotierte Gebiet (8) als Bereiche zweiten Leitungstyps gebildet werden, die sich von der Oberfläche (3) des Substrats (1) in das Substrat (1) erstrecken und
das Sourcegebiet (6) anschließend durch Einbringen eines Dotiermaterials ersten Leitungstyps durch die erste Oberfläche (3) des Substrats (1)
mit einer höheren Dotierungskonzentration als derjenigen des Bodygebiets (6) und des hochdotierten Gebietes (8) und
mit einer geringeren Eindringtiefe als die Tiefe des Bodygebiets (7) und des hochdotierte Gebiets (8) gebildet wird.

14. Verfahren nach einem der Ansprüche 12 oder 13,
**dadurch gekennzeichnet,**
**daß** nach Erzeugung des Sourcegebietes (6) ein Grabenkontakt (9) durch das Sourcegebiet (6) bis zum hochdotierten Gebiet (8) gebildet wird.

## Claims

1. Field-effect transistor arrangement with a trench-shaped gate electrode comprising
- a substrate region (1) of the first type of conduction,
- at least one trench (2) which extends from a first surface (3) of the substrate (1) into the substrate (1),
- an insulation layer (4) which covers the walls of the at least one trench (2),
- a conductive material (5) which fills the trench (2) and forms a gate electrode,
- a source region (6) of the first type of conduction which is arranged along the trench (2) and extends from the first surface (3) of the substrate (1) into the substrate (1),
- a body region (7) of the second type of conduction which is opposite to the first type of conduction, the body region (7) extending underneath the source region (6) and adjoining the source region in the vertical direction and the trench (2) in the lateral direction,
- a drain region (10) of the first type of conduction which adjoins the body region (7),
- at least one highly doped region (8) of the second type of conduction in the body region (7), the highly doped region (8) being arranged at least partially below the source region (6) and at the same time adjoining the source region (6),
**characterized in that** the highly doped region (8) adjoins the trench (2) laterally only in partial areas
and not along its entire outer edge, so that the starting voltage is higher in these partial areas than in the remaining areas of the body region (7).

2. Transistor arrangement according to Claim 1, **characterized in that** the thickness of the highly doped region (8) is at most one-third of the thickness of the body region (7).

3. Transistor arrangement according to Claim 1 or 2, **characterized in that** the thickness of the highly doped region (8) is 20% of the thickness of the body region (7) at a maximum.

4. Transistor arrangement according to one of Claims 1 to 3, **characterized in that** the transistor arrangement is constructed as a transistor cell which exhibits at least two mutually intersecting trenches (2).

5. Transistor arrangement according to Claim 4, **characterized in that** the at least one highly doped region (8) adjoins the trenches (2) in certain areas of the trenches (2) which comprise at least those areas in which the alignment of the trench wall does not correspond to a crystal plane which is equivalent to the (100) crystal plane of the substrate (1), and is arranged to be set back from the trenches (2) in the remaining area of the trenches (2).

6. Transistor arrangement according to either of Claims 4 and 5, **characterized in that** the at least one highly doped region (8) adjoins the trenches (2) in certain areas of the trenches (2) which comprise at least the corners of the transistor cell which are formed by the intersection of two trenches (2), and is arranged to be set back from the trenches (2) in the remaining area of the trenches (2).

7. Transistor arrangement according to either of Claims 5 and 6, **characterized in that** the distance between the highly doped region (8) and the trenches (2) is 1 µm at a maximum in the remaining areas in which the highly doped region (8) is arranged to be set back from the trenches (2).

8. Transistor arrangement according to one of Claims 4 to 7, **characterized in that** the transistor cell is constructed as a closed cell which is surrounded by trenches (2) on all sides and the at least one highly doped region (8) extends from the cell corners to the center of the transistor cell.

9. Transistor arrangement according to one of Claims 1 to 8, **characterized in that** the at least one highly doped region (8) is connected to a contacting part (9) of the body region (7) and of the source region (6).

10. Transistor arrangement according to Claim 9, **characterized in that** the contacting part (9) is constructed as trench contact which extends through the source region (6) to the highly doped region (8).

11. Transistor arrangement according to one of Claims 1 to 10, **characterized in that** the transistor arrangement exhibits an anode zone (11) of the second type of conduction which adjoins the drain zone (10).

12. Method for producing a body region and a source region of a field-effect transistor cell comprising a trench-shaped gate electrode, comprising the following steps:
- providing a substrate (1) of the first type of conduction with a first surface (3),
- creating trenches (2) extending from the first surface (3) of the substrate (1) into the substrate (1),
- covering the walls of the trenches (2) with an insulation layer (4),
- filling the trenches (2) with a conductive material (5) for the formation of the gate electrode,
- forming a body region (7) of the second type of conduction which is opposite to the first type of conduction, in the substrate (1), so that the body region (7) adjoins the trenches (2) after the trenches (2) have been created,
- forming a highly doped region (8) of the second type of conduction in the upper area of the body region (7),
- forming a source region (6) of the first type of conduction over the body region (7) which adjoins the body region in the vertical direction and the trenches (2) in the lateral direction after the trenches (2) have been created, and extends from the surface (3) of the substrate (1) into the substrate (1).
- **characterized in that** the highly doped region (8) adjoins the trenches (2) laterally only in partial areas
and not along its entire outer edge, after the trenches (2) have been created, so that the starting voltage is higher in these partial areas than in the remaining areas of the body region.

13. Method according to Claim 12, **characterized in that** initially, the body region (7) and the highly doped region (8) are formed as areas of the second type of conduction which extend from the surface (3) of the substrate (1) into the substrate (1) and the source region (6) is then formed by introducing a dopant of the first type of conduction through the first surface (3) of the substrate (1) with a higher doping concentration than that of the body region (6) and of the highly doped region (8) and with a lesser depth of penetration than the depth of the body region (7) and of the highly doped region (8).

14. Method according to either of Claims 12 and 13, **characterized in that** after the source region (6) has been created, a trench contact (9) through the source region (6) to the body region (7) is formed.

## Revendications

1. Ensemble de transistor à effet de champ, ayant une électrode de grille en forme de sillon et comprenant
- une zone (1) de substrat d'un premier type de conductivité,
- au moins un sillon (2), qui s'étend dans le substrat (1) à partir d'une première surface (3) du substrat (1),
- une couche (4) isolante, qui recouvre les parois du au moins un sillon (2),
- un matériau (5) conducteur, qui remplit le sillon (2) et qui forme une électrode de grille,
- une zone (6) de source du premier type de conductivité, qui est disposée le long du sillon (2) et qui s'étend dans le substrat (1) à partir de la première surface (3) du substrat (1),
- une zone (7) de body d'un deuxième type de conductivité, qui est opposé au premier type de conductivité, la zone (7) de body s'étendant en dessous de la zone (6) de source et étant ainsi voisine dans la direction verticale de la zone de source et dans la direction latérale du sillon (2),
- une zone (10) de drain du premier type de conductivité, qui est voisine de la zone (7) de body,
- au moins une zone (8) très dopée du deuxième type de conductivité dans la zone (7) de body, la zone (8) très dopée étant disposée au moins en partie en dessous de la zone (6) de source et étant ainsi voisine de la zone (6) de source,
**caractérisé**
**en ce que** la zone (8) très dopée est voisine du sillon (2), latéralement seulement dans des régions partielles
et gnon le long de tout son bord extérieur, de sorte que la tension de seuil est plus haute dans ces régions partielles que dans les régions restantes de la zone de body.

2. Ensemble de transistor suivant la revendication 1,
**caractérisé**
**en ce que** l'épaisseur de la zone (8) très dopée représente au maximum un tiers de l'épaisseur de la zone (7) de body.

3. Ensemble de transistor suivant la revendication 1 ou 2,
**caractérisé**
**en ce que** l'épaisseur de la zone (8) très dopée représente au maximum 20 % de l'épaisseur de la zone (7) de body.

4. Ensemble de transistor suivant l'une des revendications 1 à 3,
**caractérisé**
**en ce que** l'ensemble de transistor est constitué en cellule de transistor, qui a au moins deux sillons (2) qui se croisent.

5. Ensemble de transistor suivant la revendication 4,
**caractérisé**
**en ce que** la au moins une zone (8) très dopée est voisine des sillons (2) dans certaines régions de ceux-ci, qui comprennent au moins les régions dans lesquelles la direction de la paroi du sillon ne correspond pas à un plan cristallin, qui est équivalent au plan cristallin (100) du substrat (1), et est disposée dans la région rsstante des sillons (2) en retrait des sillons (2).

6. Ensemble de transistor suivant l'une des revendications 4 ou 5,
**caractérisé**
**en ce que** la au moins une zone (8) très dopée est voisine des sillons (2) en certaines parties de ceux-ci, qui comprennent au moins les coins des cellules de transistor formés par le croisement de deux sillons (2) et
est disposée en retrait des sillons (2) dans la région restante des sillons (2).

7. Ensemble de transistor suivant l'une des revendications 5 ou 6,
**caractérisé**
**en ce que** la distance de la zone (8) très dopée aux sillons (2), dans les régions restantes, dans lesquelles la région (8) très dopée est disposée en retrait des sillons (2), est au maximum de 1 µm.

8. Ensemble de transistor suivant l'une des revendications 4 à 7,
**caractérisé**
**en ce que** la cellule de transistor est constituée en cellule fermée entourée de sillons (2) de tous côtés et en ce que la au moins une zone (8) très dopée s'étend des coins de la cellule au milieu de la cellule du transistor.

9. Ensemble de transistor suivant l'une des revendications 1 à 8,
**caractérisé**
**en ce que** la au moins une zone (8) très dopée est reliée à une mise en contact (9) de la zone (7) de body et de la zone (6) de source.

10. Ensemble de transistor suivant la revendication 9,
**caractérisé**
**en ce que** la mise en contact (9) est constituée en contact de sillon qui s'étend dans la zone (6) de source jusqu'à la zone (8) très dopée.

11. Ensemble de transistor suivant l'une des revendications 1 à 10,
**caractérisé**
**en ce que** l'ensemble des transistors comporte une zone (11) d'anode du deuxième type de conductivité, qui est voisine de la zone (10) de drain.

12. Procédé de production d'une zone de body et d'une zone de source d'une cellule de transistor à effet de champ ayant une électrode de grille en forme de sillon, comprenant les stades dans lesquels :
- on se procure un substrat (1) d'un premier type de conductivité ayant une première surface (3),
- on produit des sillons, qui s'étendent dans le substrat (1) à partir de la première surface (3) du substrat (1),
- on recouvre les parois des sillons (2) d'une couche (4) isolante,
- on remplit les sillons (2) d'un matériau (5) conducteur pour former l'électrode de grille,
- on forme une zone (7) de body du deuxième type de conductivité, qui est opposé au premier type de conductivité, dans le substrat (1), de sorte que la zone (7) de body soit, après la production des sillons (2), voisine des sillons (2),
- on forme une zone (8) très dopée du deuxième type de conductivité dans la région supérieure de la zone (7) de body,
- on forme une zone (6) de source du premier type de conductivité au-dessus de la zone (7) de body, qui est voisine dans la direction verticale de la zone de body, et dans la direction latérale des sillons (2) après la production des sillons (2), et qui s'étend dans le substrat (1) à partir de la surface (3) du substrat (1),
**caractérisé**
**en ce que** la zone (8) très dopée est voisine des sillons (2), après la production de ceux-ci, latéralement seulement dans des régions partielles et non le long de tout son bord extérieur, de sorte que la tension de seuil est plus haute dans ces régions partielles que dans les régions restantes de la zone de body.

13. Procédé suivant la revendication 12,
**caractérisé**
**en ce que** l'on forme d'abord la zone (7) de body et la zone (8) très dopée comme régions du deuxième type de conductivité, qui s'étendent dans le substrat (1) à partir de la surface (3) du substrat (1) et
on forme ensuite la zone (6) de source en introduisant un matériau de dopage du premier type de conductivité à travers la première surface (3) du substrat (1),
ayant une concentration de dopage plus grande que celle de la zone (7) de body et de la zone (8) très dopée et ayant une profondeur de pénétration, qui est plus petite que la profondeur de la zone (7) de body et de la zone (8) très dopée.

14. Procédé suivant l'une des revendications 12 ou 13,
**caractérisé**
**en ce que**, après la production de la zone (6) de source, on forme un contact (9) de sillon à travers la zone (6) de source jusqu'à la zone (8) très dopée.
